(19) Europäisches Patentamt
European Patent Office
Office européen des brevets

(11) **EP 4 804 765 A1**

(12) **EUROPEAN PATENT APPLICATION**
published in accordance with Art. 153(4) EPC

(43) Date of publication:
**09.09.2026 Bulletin 2026/37**

(21) Application number: **24885378.0**

(22) Date of filing: **07.10.2024**

(51) International Patent Classification (IPC):
***H10F 10/167*** *(2025.01)* ***H10F 10/16*** *(2025.01)*
***H10F 10/161*** *(2025.01)* ***H10K 30/40*** *(2023.01)*
***H10K 39/15*** *(2026.01)*

(52) Cooperative Patent Classification (CPC):
**H10F 10/00; H10F 10/16; H10F 10/161; H10F 10/167; H10K 30/40; H10K 30/57; H10K 39/15;** Y02E 10/541

(86) International application number:
**PCT/JP2024/035832**

(87) International publication number:
**WO 2025/094603 (08.05.2025 Gazette 2025/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.10.2023 JP 2023185841**

(71) Applicants:
- **PXP Corporation**
  **Sagamihara-shi, Kanagawa 252-0203 (JP)**
- **SOLABLE Inc.**
  **Tokyo 100-7014 (JP)**

(72) Inventors:
- **SUGIMOTO, Hiroki**
  **Sagamihara-shi, Kanagawa 252-0203 (JP)**
- **HIRAI, Yoshiaki**
  **Sagamihara-shi, Kanagawa 252-0203 (JP)**
- **FUKASAWA, Kazuhito**
  **Sagamihara-shi, Kanagawa 252-0203 (JP)**

(74) Representative: **EIP**
**Fairfax House**
**15 Fulwood Place**
**London WC1V 6HU (GB)**

(54) **METHOD FOR MANUFACTURING SOLAR CELL, AND SOLAR CELL**

(57) An object of the present invention is to provide a highly productive method for manufacturing a solar cell that achieves high performance. The object can be achieved by a method for manufacturing a solar cell, including: a precursor formation step of forming a precursor including an InGaSe layer, a CuSe layer, and an InSe layer; and a crystallization step of obtaining a crystallized light-absorbing layer by heating the precursor.

Fig. 1

CuSe
InSe
InGaSe

precursor

EP 4 804 765 A1

## Description

### Technical Field

The present invention relates to a method for manufacturing a solar cell, and a solar cell.

### Background Art

Silicon solar cells manufactured using materials such as monocrystalline silicon and polycrystalline silicon are known. While such silicon solar cells exhibit excellent durability, they tend to be costly to manufacture and relatively thick, and thus are used in large-scale power generation facilities. In addition, thin-film solar cells are known, in which a light-absorbing layer in the form of a thin film is formed on a substrate such as glass and metal to provide a solar cell. The thin-film solar cells are inexpensive to manufacture and, because they are very thin, can also be used in flexible embodiments. For these reasons, in recent years, various studies have been conducted regarding conversion efficiency, durability, and the like, toward application of the thin-film solar cells.

For example, Patent Literature 1 discloses that manufacturing cost can be reduced by employing a method in which metal components such as Cu, In, and Ga are stacked by a sputtering method, and thereafter a light-absorbing layer is formed while heating in an atmosphere of $H_2Se$ or $H_2S$. Furthermore, Patent Literature 2 discloses that, in addition to the above-described method, internal defects in the thin film can be reduced by forming the light-absorbing layer while heating the substrate to a temperature equal to or higher than a crystallization temperature; however, since high-temperature heating and sputtering are performed simultaneously, there is a concern that the cost of the device will increase.

Patent Literature 3 discloses that a method is attempted in which elemental substances or alloys of Cu, In, Ga, and Se are simultaneously sputtered and then further annealed to crystallize; however, power generation performance is not sufficient. Accordingly, Patent Literature 4 discloses that the power generation performance can be improved by stacking CuSe which is a Group I-based selenide and InGaSe which is a Group III-based selenide, and crystallizing the stacked layers in an atmosphere of Se vapor or $H_2Se$ gas.

### Citation List

### Patent Literatures

Patent Literature 1: Japanese Patent Application Laid-Open No. H10-135495
Patent Literature 2: PCT Japanese Translation Patent Publication No. 2012-513127
Patent Literature 3: Pamphlet of International Publication No. 2011/052574
Patent Literature 4: Pamphlet of International Publication No. 2011/090959

### Summary of Invention

### Technical Problem

Patent Literature 1 and Patent Literature 2 disclose the methods in which, when the reaction is carried out while heating in an atmosphere of $H_2Se$ or $H_2S$, there is concern that volume expansion of the light-absorbing layer may be large, resulting in the appearance of many defects in the film and an increase in surface irregularities. Furthermore, according to the methods disclosed in Patent Literature 3 and Patent Literature 4, although defects in the film and surface irregularities can be suppressed to some extent, it is necessary to perform annealing in an atmosphere of Se vapor or $H_2Se$ gas, which requires facilities designed in consideration of environmental and safety aspects. This increases costs, and the resulting crystal grains are small, so that the power generation performance is still not sufficient.

The present invention has been made in view of the above-described problems, and an object of the present invention is to provide a method for manufacturing a solar cell, and a solar cell, both of which achieve both high performance and high productivity.

### Solution to Problem

The method for manufacturing a solar cell according to an embodiment of the present invention includes: a precursor formation step of forming a precursor including an InGaSe layer, a CuSe layer, and an InSe layer; and a crystallization step of obtaining a crystallized light-absorbing layer by heating the precursor.

In the manufacturing of the solar cell, when the precursor includes an InGaSe layer, a CuSe layer, and an InSe layer, productivity of solar cell manufacturing is improved, and the resulting solar cell exhibits high performance.

## Advantageous Effect of Invention

According to the present invention, it is possible to provide a solar cell and a method for manufacturing the same, which achieve both high performance and high productivity.

## Brief Description of Drawings

[Figure 1] Figure 1 is a schematic cross-sectional view of a precursor of a light-absorbing layer according to an embodiment of the present invention.
[Figure 2] Figure 2 is a schematic cross-sectional view of a precursor of a light-absorbing layer according to an embodiment of the present invention.
[Figure 3] Figure 3 is a schematic cross-sectional view of a precursor of a light-absorbing layer according to an embodiment of the present invention.
[Figure 4] Figure 4 is a schematic cross-sectional view of a solar cell according to an embodiment of the present invention.
[Figure 5] Figure 5 is a diagram showing X-ray diffraction patterns of respective layers included in the light-absorbing layer according to the embodiment of the present invention.
[Figure 6] Figure 6 is a diagram showing changes in X-ray diffraction patterns depending on a formation temperature of an InSe layer according to an embodiment of the present invention.

## Description of Embodiments

Hereinafter, embodiments (hereinafter, referred to as "the present embodiments") for carrying out the present invention will be described in detail with reference to drawings as necessary. However, the present invention is not limited thereto, and various modifications are possible without departing from the gist. In the drawings, the same elements will be represented by the same reference numerals, and redundant descriptions thereof will be omitted. In addition, the positional relationship such as up, down, left, and right is based on the positional relationship shown in the drawings unless otherwise specified. Furthermore, the dimensional ratios in the drawings are not limited to the ratios shown in the drawings.

1. Light-absorbing layer forming process

The method for manufacturing a solar cell according to the present embodiment includes, as a process of forming a light-absorbing layer: a precursor formation step of forming a precursor including an InGaSe layer, a CuSe layer, and an InSe layer; and a crystallization step of obtaining a crystallized light-absorbing layer by heating the precursor.

In the related art, as a method for manufacturing a CIGS-type chalcopyrite solar cell containing Cu, In, Ga, and Se, a method has been developed in which Group I-based CuSe and Group III-based InGaSe are separately stacked and then annealed in an atmosphere of Se vapor or $H_2Se$ gas to crystallize, thereby improving power generation performance. However, the solar cell obtained by the above-described method has a problem that crystal grains in a light-absorbing layer are small and crystal quality is insufficient, and thus the power generation performance cannot be said to be sufficient. In addition, since the above-described method requires annealing in an atmosphere of Se vapor or $H_2Se$ gas during the manufacturing, facilities considering environmental and safety aspects are required, leading to a concern that the cost becomes enormous.

Accordingly, the inventors of the present application have found that, by separately stacking an InGaSe layer, a CuSe layer, and an InSe layer as a precursor of a chalcopyrite light-absorbing layer and then crystallizing the precursor through heating, crystal grains of the light-absorbing layer can be enlarged and crystal quality can be improved, whereby a high-performance solar cell can be obtained; and furthermore, since a step of heating in an atmosphere containing Se element is not necessarily required, it is possible to manufacture a solar cell with high productivity.

Although the factor for the superiority of the above-described method is not necessarily clear, it is considered that, by separately forming the InGaSe layer, the CuSe layer, and the InSe layer and then crystallizing the layers, favorable seed crystals are preferentially formed at an interface between the CuSe layer and the InSe layer, whereby the crystal grains increase and the crystal quality improves. In addition, it is also presumed that relaxation of crystal strain due to the elemental profile becoming a suitable arrangement when the Se element in the film crystallizes also contributed

synergistically. However, the factors are not limited to the above.

In the present specification, "the solar cell is high-performance" means that cell characteristics related to the power generation performance of the solar cell are excellent in at least one parameter. In addition, in the present specification, "the solar cell has high productivity" means that the production cost of the solar cell is low and the reliability of the manufacturing method is high. Hereinafter, the method for manufacturing a solar cell according to the present embodiment will be described in detail.

1.1. Precursor formation step

The precursor formation step according to the present embodiment is a step of forming a precursor including an InGaSe layer, a CuSe layer, and an InSe layer. By forming the precursor including the above-described respective layers, the crystal grains of the obtained light-absorbing layer increase and the crystal quality improves, thereby improving the power generation performance.

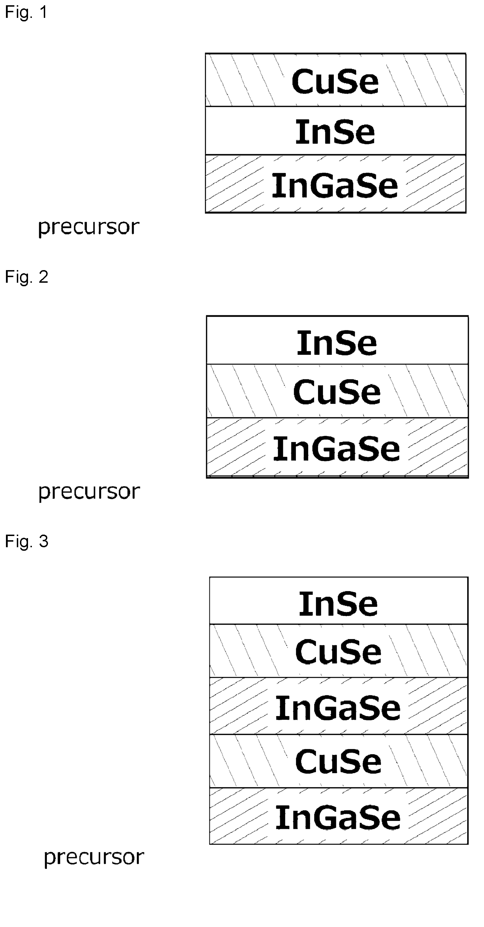

Figure 1 shows a schematic cross-sectional view serving as one example of the precursor of the light-absorbing layer. As shown in Figure 1, the precursor according to the present embodiment includes at least one InGaSe layer, one CuSe layer, and one InSe layer.

In the precursor formation step, it is preferable that the InGaSe layer or the InSe layer is amorphous, and it is more preferable that both the InGaSe layer and the InSe layer are amorphous. When the InGaSe layer or the InSe layer is amorphous, generation of unintended seed crystals in areas other than the interface with the CuSe layer is suppressed, so that the crystal grains of the obtained light-absorbing layer increase and the crystal quality improves, whereby the power generation performance tends to be further improved.

In the present specification, "being amorphous" is determined by the fact that no peak exceeding a region that is twice the upper and lower noise width centered on a baseline appears in a $2\theta$-$\theta$ pattern of X-ray diffraction measurement.

A method of forming each layer is not particularly limited, but from the viewpoint of mass productivity and reliability, it is preferable to form the layer by a sputtering method and/or a vapor deposition method, and only the sputtering method may be used.

When forming the precursor, a surface temperature of a substrate to be sputtered is preferably 300°C or lower, 250°C or lower, 200°C or lower, or room temperature (RT). By setting the temperature of the substrate to be sputtered within the above-described range, the InGaSe layer and the InSe layer tend to become amorphous layers, and the resulting solar cell tends to have higher performance and higher productivity. In the present specification, the substrate to be sputtered refers to a substrate on a stage during sputtering, on which a compound derived from a sputtering target is stacked.

The target used for the sputtering is not particularly limited, and for forming each layer, for example, an elemental substance or a mixture of In, $In_4Se_3$, InSe, $In_2Se_3$, GaSe, $Ga_2Se_3$, and Se may be used for the InGaSe layer; an elemental substance or a mixture of Cu, $Cu_2Se$, $CuSe_2$, and Se may be used for the CuSe layer; and an elemental substance or a mixture of In, $In_4Se_3$, InSe, $In_2Se_3$, and Se may be used for the InSe layer. Among the above, it is preferable to use: for the InGaSe layer, a mixture of $In_2Se_3$ and $Ga_2Se_3$, with a proportion of $Ga_2Se_3$ being 30% or more and 60% or less; for the CuSe layer, $CuSe_2$ alone; and for the InSe layer, $In_2Se_3$ alone.

Examples of gas supplied during the sputtering include inert gases such as Ar and He, $H_2$, $H_2Se$, and $H_2S$. Among the above, from the viewpoint of more reliably achieving the effects of the present invention, Ar is preferable as the inert gas, and $H_2$ is preferable as the other gas.

In the precursor formation step, it is preferable to form the InSe layer on a light-receiving surface side with respect to the InGaSe layer. By forming the InSe layer on the light-receiving surface side with respect to the InGaSe layer, the power generation performance of the obtained solar cell tends to be further improved.

In the precursor formation step, it is preferable to form the InSe layer closest to the light-receiving surface side. When the InSe layer is formed closest to the light-receiving surface side, the power generation performance of the obtained solar cell tends to be further improved. From the same viewpoint, it is preferable to form the InSe layer closest to the light-receiving surface side and form the CuSe layer as the second layer on the light-receiving surface side.

Figure 2 shows a schematic cross-sectional view serving as another example of the precursor of the light-absorbing layer. As shown in Figure 2, the precursor according to the present embodiment includes an InGaSe layer, a CuSe layer, and an InSe layer, and it is preferable to form the InSe layer on the light-receiving surface side with respect to the InGaSe layer. In addition, as shown in Figure 2, the precursor according to the present embodiment includes an InGaSe layer, a CuSe layer, and an InSe layer, and it is preferable to form the InSe layer closest to the light-receiving surface side.

In the precursor formation step, it is preferable that two or more layers, three or more layers, or five or more layers of each of the InGaSe layer and the CuSe layer are formed. By providing two or more layers of each of the InGaSe layer and the CuSe layer, the power generation performance of the obtained solar cell tends to be further improved.

Figure 3 shows a schematic cross-sectional view serving as another example of the precursor of the light-

absorbing layer. As shown in Figure 3, the precursor according to the present embodiment includes an InGaSe layer, a CuSe layer, and an InSe layer, and it is preferable to form two or more layers of each of the InGaSe layer and the CuSe layer. In addition, as shown in Figure 3, the precursor according to the present embodiment includes an InGaSe layer, a CuSe layer, and an InSe layer, and it is preferable to form the InSe layer closest to the light-receiving surface side.

In the entire precursor to be formed, a ratio value (Ga/(In + Ga)) of an amount of substance of Ga element to the total amount of substance of In element and Ga element is preferably 0.10 or more and 0.50 or less, 0.15 or more and 0.40 or less, or 0.20 or more and 0.40 or less. By setting the amount-of-substance ratio of (Ga/(In + Ga)) in the entire precursor within the above-described range, the power generation performance of the obtained solar cell tends to be further improved.

In addition, in the entire precursor to be formed, a ratio value (Cu/(In + Ga)) of an amount of substance of Cu element to the total amount of substance of In element and Ga element is preferably 0.50 or more and 1.0 or less, 0.75 or more and 0.95 or less, or 0.80 or more and 0.90 or less. By setting the amount-of-substance ratio of (Cu/(In + Ga)) in the entire precursor within the above-described range, the power generation performance of the obtained solar cell tends to be further improved.

In the entire precursor to be formed, a ratio value (Se/(Cu + In + Ga)) of an amount of substance of Se element to the total amount of substance of Cu element, In element, and Ga element is preferably 0.5 or more, 0.8 or more, or 1.0 or more. By setting the amount-of-substance ratio of (Se/(Cu + In + Ga)) within the above-described range, the amount of Se element in the precursor becomes sufficient, and the power generation performance and the productivity of the obtained solar cell tend to be further improved. Moreover, the upper limit of the amount-of-substance ratio of (Se/(Cu + In + Ga)) is not particularly limited, and may be, for example, 10.0 or less, 7.5 or less, 5.0 or less, or 3.0 or less.

In the InGaSe layer, a ratio value (Ga/(In + Ga)) of an amount of substance of Ga element to the total amount of substance of In element and Ga element is preferably 0.1 or more and 0.8 or less, 0.2 or more and 0.7 or less, 0.3 or more and 0.6 or less, or 0.4 or more and 0.6 or less. By setting the amount-of-substance ratio of (Ga/(In + Ga)) in the InGaSe layer within the above-described range, the power generation performance of the obtained solar cell tends to be further improved.

A ratio value (Y/X) of the total amount of substance Y of In element and Ga element in the InGaSe layer to an amount of substance X of In element in the InSe layer is preferably 0.5 or more and 2.5 or less, 0.6 or more and 2.3 or less, 0.8 or more and 2.0 or less, or 1.0 or more and 1.5 or less. By setting the amount-of-substance ratio (Y/X) within the above-described range, the power generation performance of the obtained solar cell tends to be further improved.

In the InGaSe layer and the InSe layer, a ratio value (Se/(In + Ga)) of an amount of substance of Se element to the total amount of substance of In element and Ga element is preferably 0.8 or more and 2.0 or less, 0.9 or more and 1.9 or less, or 1.0 or more and 1.75 or less.

When the CuSe layer is formed as an outermost layer of the precursor, the value of (Se/(In + Ga)) in the InGaSe layer and the InSe layer is preferably 1.0 or more and 2.0 or less, or 1.25 or more and 1.75 or less.

When the CuSe layer is formed as a layer other than the outermost layer of the precursor, the value of (Se/(In + Ga)) in the InGaSe layer and the InSe layer is preferably 1.0 or more and 2.0 or less, or 1.0 or more and 1.5 or less.

When the value of (Se/(In + Ga)) in the InGaSe layer and the InSe layer is within the above-described range, the power generation performance of the obtained solar cell tends to be further improved.

In the present specification, the outermost layer of the precursor means a layer located closest to the light-receiving surface side.

The amount-of-substance ratio (Se/Cu) in the CuSe layer is preferably 0.5 or more and 4.0 or less, or 0.5 or more and 3.0 or less.

When the CuSe layer is formed as the outermost layer of the precursor, in the CuSe layer, the ratio value (Se/Cu) of an amount of substance of Se element to an amount of substance of Cu element is preferably 1.5 or more and 5.0 or less, 1.5 or more and 4.0 or less, 2.0 or more and 3.0 or less, or 2.2 or more and 2.7 or less.

When the CuSe layer is formed as a layer other than the outermost layer of the precursor, in the CuSe layer, the ratio value (Se/Cu) of the amount of substance of Se element to the amount of substance of Cu element is preferably 0.3 or more and 2.5 or less, 0.4 or more and 2.2 or less, or 0.5 or more and 2.0 or less.

By setting the ratio value (Se/Cu) of the amount of substance of Se element to the amount of substance of Cu element in the CuSe layer within the above-described range, the power generation performance of the obtained solar cell tends to be further improved.

A method of examining the content of elements in each layer of the precursor is not particularly limited, and for example, emission spectroscopic analysis using inductively coupled plasma (ICP), energy dispersive X-ray analysis (EDX or EDS), secondary ion mass spectrometry (SIMS), or the like can be used.

Examples of a method of adjusting the content of elements in each layer in the precursor formation step include a method of adjusting the content of elements in a raw material (target) to be used during sputtering or vapor deposition, and a method of controlling film formation pressure or applied power.

A thickness of the precursor to be formed may be adjusted as needed depending on the configuration and

purpose of the solar cell. The thickness of the entire precursor is preferably 700 nm or more and 3200 nm or less, or 1500 nm or more and 2700 nm or less.

A thickness of the InGaSe layer to be formed is preferably 300 nm or more and 1300 nm or less, or 600 nm or more and 1200 nm or less per layer.

A thickness of the CuSe layer to be formed is preferably 100 nm or more and 700 nm or less, or 300 nm or more and 600 nm or less per layer.

A thickness of the InSe layer to be formed is preferably 300 nm or more and 1200 nm or less, or 600 nm or more and 1100 nm or less per layer.

By setting the thickness of each layer in the precursor formation step as described above, the power generation performance of the obtained solar cell can be more reliably improved.

1.2. Crystallization step

The crystallization step according to the present embodiment is a step of obtaining a light-absorbing layer by crystallizing the formed precursor through heating. The heating may be performed only once, or may be performed stepwise in two or more times.

A heating temperature in the crystallization step is preferably 300°C or higher and 600°C or lower, 320°C or higher and 600°C or lower, 350°C or higher and 600°C or lower, or 400°C or higher and 600°C or lower. By setting the heating temperature within the above-described range, the crystal grains of the light-absorbing layer increase and the crystal quality improves, whereby the power generation performance of the obtained solar cell tends to be further improved.

The crystallization step may be performed in an inert atmosphere or an atmosphere containing Se element, and is preferably performed in an inert atmosphere. By performing the crystallization in an inert atmosphere, the power generation performance of the solar cell can be more reliably improved. Examples of the inert gas include nitrogen ($N_2$) and argon (Ar), and nitrogen is preferably used.

1.3. Surface treatment step

It is preferable that the method for manufacturing a solar cell according to the present embodiment further includes, after the above-described crystallization step, a surface treatment step of treating a surface of the light-absorbing layer in a sulfur atmosphere at 350°C or higher and 600°C or lower. By performing the surface treatment step, a band gap on the light-receiving surface side of the light-absorbing layer can be controlled, so that the solar cell tends to have higher performance.

A temperature of the atmosphere during the surface treatment may be 400°C or higher and 600°C or lower, or may be 500°C or higher and 600°C or lower. By performing the surface treatment step within the above-described temperature range, the solar cell tends to have higher performance.

A time for the surface treatment step may be, for example, 1 minute or longer and 60 minutes or shorter, or may be 3 minutes or longer and 30 minutes or shorter. By setting the time for performing the surface treatment step within the above-described range, the solar cell tends to have higher performance.

2. Solar cell

The solar cell according to the present embodiment includes a light-absorbing layer 104 manufactured by the above-described method, and has a configuration described later. A solar cell including the light-absorbing layer 104 manufactured by the above-described manufacturing method is excellent in conversion efficiency and high performance, and is also excellent in productivity because the manufacturing process can be simplified.

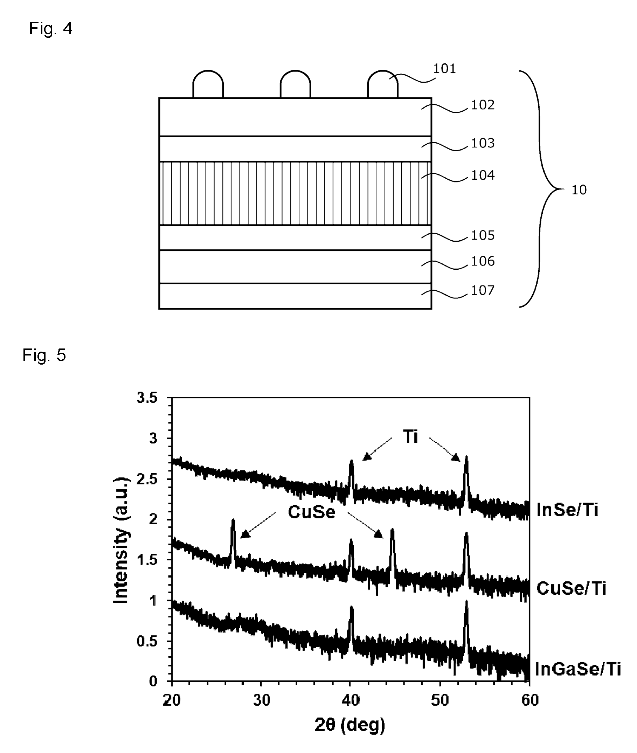

Figure 4 shows an example of a cross-sectional structure of the solar cell according to the present embodiment.

As shown in Figure 4, for example, a solar cell 10 includes a substrate 107, a first electrode layer 106 provided on the substrate 107, a hole transport layer 105 provided on the first electrode layer 106, a light-absorbing layer 104 provided on the hole transport layer 105, an electron transport layer 103 provided on the light-absorbing layer 104, a second electrode layer 102 provided on the electron transport layer 103, and a grid electrode 101 provided on the second electrode layer 102. The solar cell 10 receives light from the second electrode layer 102 side to generate power.

Hereinafter, each layer constituting the solar cell 10 will be described.

2.1. Substrate

The substrate 107 is not particularly limited, and for example, a glass substrate such as soda-lime glass and low-alkali glass; a metal substrate such as stainless steel foil, aluminum foil, and titanium foil; or a resin substrate such as a polyimide resin film and an epoxy resin film can be used. A thickness of the substrate 107 is not particularly limited, and is,

for example, 10 μm or more and 500 μm or less, 20 μm or more and 250 μm or less, or 30 μm or more and 100 μm or less. When the thickness of the substrate 107 is within the above-described range, it is preferable in that the solar cell can be made lighter and flexible.

2.2. First electrode layer

Generally, the first electrode layer 106 is provided for extracting current due to holes generated in the light-absorbing layer 104 described later. The first electrode layer 106 is not particularly limited as long as it has conductivity, and for example, a metal conductive layer made of a metal such as Mo, Cr, and Ti; a conductive inorganic compound conductive layer made of a conductive inorganic compound other than a metal; or a conductive organic compound conductive layer made of a conductive organic compound can be used. A thickness of the first electrode layer 106 is not particularly limited, and is, for example, 200 nm or more and 800 nm or less, or 300 nm or more and 700 nm or less. When the thickness of the first electrode layer 106 is within the above-described range, it is preferable in that the solar cell can be made lighter and flexible while sufficiently extracting current without loss.

2.3. Hole transport layer

The hole transport layer 105 has a function of, for example, efficiently extracting holes generated in the light-absorbing layer 104 described later from the light-absorbing layer 104, and preventing recombination of electrons and holes generated simultaneously in the light-absorbing layer 104 described later. The hole transport layer 105 is preferably a p-type semiconductor; and substances contained in the p-type semiconductor are not particularly limited, and examples thereof include organic compounds such as polythiophene derivatives such as poly(3,4-ethylene-dioxythiophene):polystyrenesulfonate (PEDOT:PSS), poly(3-hexylthiophene) (P3HT), and poly(3-octylthiophene) (P3OT); fluorene derivatives such as 2,2'-7,7'-tetrakis-(N,N-di-p-methoxyphenylamine)-9,9'-spirobifluorene (spiro-MeO-TAD); carbazole derivatives such as polyvinylcarbazole; triphenylamine derivatives; diphenylamine derivatives; polysilane derivatives; and polyaniline derivatives; and inorganic compounds such as nickel oxide, molybdenum oxide, copper gallium oxide, copper aluminum oxide, molybdenum selenide, and molybdenum selenosulfide. The p-type semiconductor as the hole transport layer 105 may be used alone or in combination of two or more. In the solar cell, formation of the hole transport layer 105 may be omitted.

2.4. Light-absorbing layer

2.4.1. Light-absorbing layer according to present embodiment

The light-absorbing layer 104 has a function of absorbing light such as near-infrared light, visible light, and ultraviolet light to generate electrons and holes, and examples of such light include sunlight.

The light-absorbing layer 104 in the solar cell according to the present embodiment contains CIGS-type chalcopyrite obtained by the precursor formation step and crystallization step described above. In addition, when the above-described surface treatment step is additionally performed on the obtained light-absorbing layer 104, since a sulfur component is further contained, it can be said that the light-absorbing layer 104 contains CIGSS-type (containing Cu, In, Ga, Se, and S) chalcopyrite.

A band gap of the light-absorbing layer 104 according to the present embodiment is preferably 2.0 eV or less, 1.8 eV or less, 1.5 eV or less, 1.2 eV or less, or 1.1 eV or less, based on the minimum value in a depth direction. In addition, the lower limit of the band gap may be, for example, 0.5 eV or 0.8 eV or more. When the band gap of the light-absorbing layer 104 satisfies the above-described range, the solar cell has high performance.

As a method of measuring the band gap, a known method can be used. Specifically, the band gap can be measured by, for example, spectral transmittance measurement or spectral quantum efficiency measurement.

In the light-absorbing layer 104 according to the present embodiment, a band gap in a section from the light-receiving surface side to a depth of 200 nm is preferably 1.1 eV or more and 1.4 eV or less; a band gap in a section from a depth of 200 nm to a depth of 400 nm is preferably 0.9 eV or more and 1.2 eV or less; and a band gap in a section at a depth of 400 nm or more is 1.2 eV or more and 1.7 eV or less. By setting the band gaps within the above-described ranges, it tends to be possible to prevent recombination of electrons and holes generated by light absorption.

A thickness of the light-absorbing layer 104 according to the present embodiment per layer is preferably 0.5 μm or more and 5 μm or less, 0.8 μm or more and 4 μm or less, or 1 μm or more and 3 μm or less. By setting the thickness of the light-absorbing layer 104 per layer within the above-described range, the productivity of the solar cell is further improved, and weight reduction and flexibility tend to be facilitated.

A ratio of the light-absorbing layer 104 according to the present embodiment is not particularly limited, and is, for example, 50% by mass or more and 100% by mass or less, 60% by mass or more and 100% by mass or less, 70% by mass

or more and 100% by mass or less, 80% by mass or more and 100% by mass or less, or 90% by mass or more and 100% by mass or less with respect to the total mass of the light-absorbing layer 104.

2.4.2. Additional light-absorbing layer

The solar cell may have an additional light-absorbing layer different from the light-absorbing layer 104. Regarding such an additional light-absorbing layer, for example, an aspect of including a further hole transport layer on the second electrode layer 102 of the solar cell already including the light-absorbing layer and including an additional light-absorbing layer is conceivable; and when no further hole transport layer is provided, an additional light-absorbing layer may be provided on the second electrode layer 102.

Examples of a compound serving as the additional light-absorbing layer include those containing a perovskite compound, a chalcopyrite compound, or a kesterite compound. Each compound may be used alone, or two or more kinds of perovskite, chalcopyrite, or kesterite may be used in combination.

Examples of the perovskite compound include organic-inorganic perovskite compounds, in particular, halide-based organic-inorganic perovskite compounds. Specific examples thereof include $CH_3NH_3PbI_3$, $CH_3NH_3PbBr_3$, $CH_3NH_3PbCl_3$, $CH_3NH_3SnI_3$, $CH_3NH_3SnBr_3$, $CH_3NH_3SnCl_3$, $CH_3NH_3PbI_{(3-x)}Cl_x$, $CH_3NH_3PbI_{(3-x)}Br_x$, $CH_3NH_3PbBr_{(3-x)}Cl_x$, $CH_3NH_3Pb_{(1-y)}Sn_yI_3$, $CH_3NH_3Pb_{(1-y)}Sn_yBr_3$, $CH_3NH_3Pb_{(1-y)}Sn_yCl_3$, $CH_3NH_3Pb_{(1-y)}Sn_yI_{(3-x)}Cl_x$, $CH_3NH_3Pb_{(1-y)}Sn_yI_{(3-x)}Br_x$, and $CH_3NH_3Pb_{(1-y)}Sn_yBr_{(3-x)}Cl_x$, and a compound in which $CFH_2NH_3$, $CF_2HNH_3$, $CF_3NH_3$, or $NH_2CH=NH_2$ is used instead of $CH_3NH_3$ in the above-described compounds. In the above-described formulae, x represents an arbitrary value of 0 or more and 3 or less, and y represents an arbitrary value of 0 or more and 1 or less.

Examples of the chalcopyrite compound different from the CIGS-type chalcopyrite compound obtained by the manufacturing method according to the present invention include $CuAlS_2$, $CuAlSe_2$, $CuAlTe_2$, $CuGaS_2$, $CuGaSe_2$, $CuGaTe_2$, $CuInS_2$, $CuInSe_2$, $CuInTe_2$, $AgAlS_2$, $AgAlSe_2$, $AgAlTe_2$, $AgGaS_2$, $AgGaSe_2$, $AgGaTe_2$, $AgInS_2$, $AgInSe_2$, $AgInTe_2$, and combinations thereof. The "combinations thereof" are not particularly limited, and include, for example, $Cu(In_xGa_{1-x})(Se_yS_{1-y})_2$ ($0 \leq x \leq 1$, $0 \leq y \leq 1$) when $CuGaS_2$ and $CuInSe_2$ are combined.

Examples of the kesterite compound include $I_2$-II-IV-$VI_4$-group kesterite compounds, and more specifically, $Cu_2ZnSnS_4$, $Cu_2ZnSnSe_4$, $Cu_2ZnGeS_4$, $Cu_2ZnGeSe_4$, $Cu_2MnSnS_4$, $Cu_2MnSnSe_4$, $Cu_2MnGeS_4$, $Cu_2MnGeSe_4$, $Ag_2ZnSnS_4$, $Ag_2ZnSnSe_4$, $Ag_2ZnGeS_4$, $Ag_2ZnGeSe_4$, $Ag_2MnSnS_4$, $Ag_2MnSnSe_4$, $Ag_2MnGeS_4$, $Ag_2MnGeSe_4$, and combinations thereof. The "combinations thereof" are not particularly limited, and include, for example, $(Cu_xAg_{1-x})_2ZnSn(S_ySe_{1-y})_4$ ($0 \leq x \leq 1$) when $Cu_2ZnSnS_4$ and $Ag_2ZnSnSe_4$ are combined.

2.5. Electron transport layer

The electron transport layer 103 has a function of, for example, efficiently extracting electrons generated in the light-absorbing layer 104 from the light-absorbing layer 104 and preventing recombination of electrons and holes generated simultaneously with electrons in the light-absorbing layer 104. The electron transport layer 103 is preferably an n-type semiconductor; and substances contained in the n-type semiconductor are not particularly limited, and examples thereof include organic compounds such as $C_{60}$, phenanthroline derivatives like 2,9-dimethyl-4,7-diphenyl-1,10-phenanthroline (BCP), phenylpyridine derivatives like 4,6-bis(3,5-di-4-pyridinylphenyl)-2-methylpyrimidine (B4PymPm) and tris(2,4,6-trimethyl-3-(pyridin-3-yl)phenyl)borane (3TPYMB); n-type oxide semiconductors consisting essentially of zinc oxide, tin oxide, titanium oxide, zinc oxysulfide, zinc magnesium oxide, zinc tin oxide, or zinc titanium oxide; and n-type semiconductors containing cadmium sulfide, indium sulfide, or indium sulfide to which an oxygen element or an alkali metal element is added. The n-type semiconductor in the electron transport layer 103 may be used alone or in combination of two or more. A thickness of the electron transport layer 103 is, for example, 50 nm or more and 200 nm or less, 60 nm or more and 150 nm or less, or 75 nm or more and 135 nm or less. When the thickness of the electron transport layer 103 is within the above-described range, it is preferable in that the solar cell can be made lighter and flexible while having the above-described functions.

2.6. Second electrode layer

The second electrode layer 102 is provided, for example, for extracting current due to the electrons generated in the light-absorbing layer 104. In the solar cell, typically, since the light-absorbing layer 104 absorbs light that has passed through the second electrode layer 102, it is preferable to make the second electrode layer 102 a transparent electrode layer in order to increase the amount of light absorbed by the light-absorbing layer 104. As a material for the transparent electrode, a known material can be used, and examples thereof include indium tin oxide (ITO), hydrogen-containing indium oxide (IOH), fluorine-containing tin oxide (FTO), boron-containing zinc oxide (ZnO:B), and aluminum-containing zinc oxide (ZnO:Al). A thickness of the second electrode layer 102 is not particularly limited, and is, for example, 100 nm or more and 1500 nm or less, or 200 nm or more and 1000 nm or less. When the thickness of the second electrode layer 102 is

within the above-described range, it is preferable in that the solar cell can be made lighter and flexible while sufficiently extracting current without loss.

2.7. Grid electrode

The grid electrode 101 is provided, for example, for extracting electricity from the second electrode layer 102. A material for the grid electrode 101 is not particularly limited as long as it has conductivity, and for example, a metal such as Mo, Cr, Ag, Cu, Ni, Al, and Ti; a conductive inorganic compound other than a metal; or a conductive organic compound can be used. A thickness of the grid electrode 101 is not particularly limited, and is, for example, 5 μm or more and 50 μm or less. When the thickness of the grid electrode 101 is within the above-described range, it is preferable in that the solar cell can be made lighter and flexible.

2.8. Modification example

The solar cell 10 shown in Figure 4 is an illustration for explaining the solar cell according to the embodiment of the present invention, and is not intended to limit the present invention only to that embodiment, and the solar cell according to the embodiment of the present invention can be variously modified without departing from the gist thereof.

For example, the solar cell 10 may include another layer between the respective layers, on the grid electrode 101, or under the substrate 107 as needed. Specifically, the hole transport layer 105 may have two or more hole transport layers each containing a different material, and a contamination prevention layer for preventing contamination from the outside may be provided on the grid electrode 101. In addition, another hole transport layer may be provided on the second electrode layer 102 instead of the grid electrode 101, and an additional light-absorbing layer may be provided thereon; and the electron transport layer 103 may have two or more electron transport layers 103 each containing a different material. However, at least one layer among the light-absorbing layers is the light-absorbing layer 104 obtained by the manufacturing method according to the present embodiment.

Although not shown, the solar cell 10 may be configured such that the hole transport layer 105, the light-absorbing layer 104 provided on the hole transport layer 105, the electron transport layer 103 provided on the light-absorbing layer, and the second electrode layer 102 provided on the electron transport layer 103 constitute one set, and two sets or three sets of the above-described set are stacked on the first electrode layer 106. In addition, a grid electrode may be provided on the uppermost second electrode layer.

When there are a plurality of any of the respective layers 101 to 107, the plurality of layers may be the same as or different from each other. For example, when a plurality of light-absorbing layers 104 are provided, each light-absorbing layer may contain compounds having different absorption spectra, and the electron transport layer and the hole transport layer in contact with each light-absorbing layer may be selected according to the properties of the light-absorbing layer in contact therewith. However, at least one layer among the light-absorbing layers is the light-absorbing layer 104 obtained by the above-described manufacturing method.

The solar cell according to the present embodiment can be used in a normal temperature environment in which the temperature of the solar cell reaches approximately 45°C to 85°C, similarly to conventional solar cells. For example, the solar cell according to the present embodiment can be suitably used as a power generation device attached to windows or walls of buildings or transportation means, as an independent power supply device for streetlights or sensors, as a mobile energy device, and as a power generation device in space or the stratosphere.

The solar cell according to the present embodiment has high conversion efficiency. More specifically, the conversion efficiency of the solar cell according to the present embodiment is preferably 14% or more, 15% or more, or 16% or more. Having the conversion efficiency in the above-described range indicates that a high-performance solar cell is obtained.

A thickness of the solar cell excluding the substrate 107 is not particularly limited, and is, for example, 1.0 μm or more and 10.0 μm or less, 1.1 μm or more and 8.0 μm or less, or 1.2 μm or more and 6.0 μm or less. The solar cell according to the embodiment of the present invention can constitute a thin-film solar cell by forming each layer sufficiently thin.

3. Method for manufacturing solar cell

Next, the method for manufacturing a solar cell according to the present embodiment shown in Figure 4 will be described.

3.1. First electrode layer formation step

First, for example, the first electrode layer 106 is formed on the substrate 107. Examples of a method of forming

the first electrode layer 106 include a dry process and a wet process, and a dry process is preferable. The dry process is not particularly limited, and examples thereof include a method of forming the first electrode layer 106 that is a metal conductive layer, by a sputtering method. Film formation conditions for the sputtering method are not particularly limited, and may be, for example, applied power: 1.0 to 3.0 W/cm$^2$, film formation atmosphere: argon atmosphere, and film formation pressure: 0.5 to 3.0 Pa. In the first electrode layer formation step, for example, the substrate 107 may be used as a substrate to be sputtered. In the present specification, the substrate to be sputtered refers to a substrate on a stage during sputtering, on which a compound derived from a sputtering target is stacked.

3.2. Hole transport layer formation step

Next, for example, the hole transport layer 105 is formed on the first electrode layer 106. Examples of a method of forming the hole transport layer 105 include a dry process and a wet process, and a dry process is preferable. The dry process is not particularly limited, and examples thereof include a method of forming the hole transport layer 105 that is a p-type semiconductor containing an organic compound or an inorganic compound, by a sputtering method. Film formation conditions for the sputtering method are not particularly limited, and may be, for example, applied power: 0.5 to 3.0 W/cm$^2$, film formation atmosphere: argon atmosphere or mixed atmosphere of argon and oxygen, and film formation pressure: 0.5 to 3.0 Pa. In addition, when forming the light-absorbing layer 104, a compound of an element of the first electrode layer 106 and an element contained in the light-absorbing layer 104 may be formed to form the hole transport layer 105 between the first electrode layer 106 and the light-absorbing layer 104.

3.3. Light-absorbing layer formation step

Next, the light-absorbing layer 104 is formed on the hole transport layer 105. A method of forming the light-absorbing layer 104 is as described in "1. Light-absorbing layer forming process".

3.4. Electron transport layer formation step

Next, the electron transport layer 103 is formed on the light-absorbing layer 104. For example, the electron transport layer 103 may be formed on the substrate to be sputtered, including the light-absorbing layer 104, by forming a film of an n-type oxide semiconductor by a sputtering method while supplying a gas containing an oxygen source and a hydrogen source, or by forming a film of an n-type oxide semiconductor by a sputtering method while supplying a gas containing no hydrogen source. Film formation conditions of the sputtering method are not particularly limited, and may be, for example, applied power: 0.5 to 3.0 W/cm$^2$, film formation atmosphere: argon atmosphere capable of including oxygen, and film formation pressure: 0.5 to 3.0 Pa. In addition, it is preferable to heat the substrate to be sputtered during the sputtering.

3.5. Second electrode layer formation step

Next, the second electrode layer 102 is formed on the electron transport layer 103. Examples of a method of forming the second electrode layer 102 include a dry process and a wet process, and a dry process is preferable. The dry process is not particularly limited, and examples thereof include a method of forming the second electrode layer 102 that is a transparent electrode layer, by a sputtering method. Film formation conditions for the sputtering method are not particularly limited, and may be, for example, applied power: 0.5 to 3.0 W/cm$^2$, film formation atmosphere: argon atmosphere or mixed atmosphere of argon, oxygen, and hydrogen, and film formation pressure: 0.5 to 3.0 Pa.

3.6. Grid electrode formation step

Next, the grid electrode 101 is formed on the second electrode layer 102. Examples of a method of forming the grid electrode 101 include a dry process and a wet process. Specifically, examples thereof include a sputtering method, a vapor deposition method, a method of printing a paste-like conductive material on the second electrode layer 102, and a method of crimping a conductive wire.

After forming the light-absorbing layer 104 and before forming the grid electrode, an additional light-absorbing layer formation step may be provided. As such an additional light-absorbing layer formation step, for example, it is conceivable to form a further hole transport layer on the second electrode layer 102 and then form an additional light-absorbing layer; and when no hole transport layer is provided, an additional light-absorbing layer may be formed on the second electrode layer. Examples of a method of forming the additional light-absorbing layer include a dry process and a wet process, and a dry process is preferable. The dry process is not particularly limited, and examples thereof include a method of forming an additional light-absorbing layer containing a perovskite compound, a chalcopyrite compound, or a

kesterite compound by a sputtering method. Film formation conditions for the sputtering method are not particularly limited, and may be, for example, applied power: 0.5 to 3.0 W/cm$^2$, film formation atmosphere: argon atmosphere, and film formation pressure: 0.2 to 3.0 Pa. In addition, a step of annealing at 80°C or higher and 200°C or lower in a nitrogen or iodine atmosphere may be included after the sputtering. Alternatively, a step of annealing at 350°C or higher and 650°C or lower in an atmosphere of nitrogen or selenium and sulfur may be included after the sputtering.

< Addenda >

The embodiment of the present disclosure includes the following aspects.

[1] A method for manufacturing a solar cell, including:

a precursor formation step of forming a precursor including an InGaSe layer, a CuSe layer, and an InSe layer; and
a crystallization step of obtaining a crystallized light-absorbing layer by heating the precursor.

[2] The method for manufacturing a solar cell according to [1], in which, in the precursor formation step, the InGaSe layer and the InSe layer are amorphous.
[3] The method for manufacturing a solar cell according to [1] or [2], in which, in the precursor formation step, the respective layers are formed by a sputtering method and/or a vapor deposition method at 200°C or lower.
[4] The method for manufacturing a solar cell according to any one of [1] to [3], in which, in the precursor formation step, the InSe layer is formed on a light-receiving surface side with respect to the InGaSe layer.
[5] The method for manufacturing a solar cell according to any one of [1] to [4], in which, in the precursor formation step, the InSe layer is formed closest to a light-receiving surface side.
[6] The method for manufacturing a solar cell according to any one of [1] to [5], in which, in the precursor formation step, two or more layers of each of the InGaSe layer and the CuSe layer are formed.
[7] The method for manufacturing a solar cell according to any one of [1] to [6], in which, in the InGaSe layer, a ratio value (Ga/(In + Ga)) of an amount of substance of Ga element to a total amount of substance of In element and Ga element is 0.3 or more and 0.6 or less.
[8] The method for manufacturing a solar cell according to any one of [1] to [7], in which a ratio value (Y/X) of a total amount of substance Y of In element and Ga element in the InGaSe layer to an amount of substance X of In element in the InSe layer is 0.5 or more and 2.5 or less.
[9] The method for manufacturing a solar cell according to any one of [1] to [8], in which, in the precursor,

a ratio value (Ga/(In + Ga)) of an amount of substance of Ga element to a total amount of substance of In element and Ga element is 0.15 or more and 0.40 or less,
a ratio value (Cu/(In + Ga)) of an amount of substance of Cu element to the total amount of substance of In element and Ga element is 0.75 or more and 0.95 or less, and
a ratio value (Se/(Cu + In + Ga)) of an amount of substance of Se element to a total amount of substance of Cu element, In element, and Ga element is 1.0 or more.

[10] The method for manufacturing a solar cell according to any one of [1] to [9], in which, in the InGaSe layer and the InSe layer, a ratio value (Se/(In + Ga)) of an amount of substance of Se element to a total amount of substance of In element and Ga element is 1.25 or more and 1.75 or less.
[11] The method for manufacturing a solar cell according to any one of [1] to [10], in which, when the CuSe layer is formed as an outermost layer of the precursor, in the CuSe layer, a ratio value (Se/Cu) of an amount of substance of Se element to an amount of substance of Cu element is 2.0 or more and 3.0 or less.
[12] The method for manufacturing a solar cell according to any one of [1] to [11], in which, when the CuSe layer is formed as a layer other than an outermost layer of the precursor, in the CuSe layer, a ratio value (Se/Cu) of an amount of substance of Se element to an amount of substance of Cu element is 0.5 or more and 2.0 or less.
[13] The method for manufacturing a solar cell according to any one of [1] to [12], in which, in the crystallization step, the heating is performed under an inert atmosphere at 300°C or higher and 600°C or lower.
[14] The method for manufacturing a solar cell according to any one of [1] to [13], further including, after the crystallization step: a surface treatment step of treating a surface of the light-absorbing layer under a sulfur atmosphere at 350°C or higher and 600°C or lower.
[15] A solar cell manufactured by the method according to any one of [1] to [14], in which, in the light-absorbing layer,

a band gap in a section from a light-receiving surface side to a depth of 200 nm is 1.1 eV or more and 1.4 eV or less,
a band gap in a section from a depth of 200 nm to a depth of 400 nm measured from the light-receiving surface side

is 0.9 eV or more and 1.2 eV or less, and
a band gap in a section at a depth of more than 400 nm measured from the light-receiving surface side is 1.2 eV or more and 1.7 eV or less.

Examples

Hereinafter, the present embodiment will be described more specifically using Examples and Comparative Examples. The present invention is not limited in any way by the following examples.

<Method for producing solar cell>

A solar cell including a single electron transport layer as shown in Figure 4 was produced. A titanium foil having a thickness of 50 μm was used as a substrate. A first electrode layer containing metallic molybdenum was formed to a thickness of 600 nm on the substrate by a sputtering method. The light-absorbing layer according to the present embodiment was formed thereon under conditions described later. Here, when crystals of the light-absorbing layer were formed, a 50 nm MoSe layer serving as a hole transport layer was formed together between the light-absorbing layer and the first electrode layer. Furthermore, the obtained light-absorbing layer was annealed in a sulfur atmosphere at 500°C or higher and 600°C or lower for 3 minutes or longer and 30 minutes or shorter to perform surface treatment.

Next, an n-type electron transport layer containing titanium zinc oxide to which hydrogen element and sulfur element were added was formed to a thickness of 70 nm or more and 120 nm or less on the light-absorbing layer by a sputtering method; hydrogen-containing indium oxide was formed to 300 nm as a second electrode layer on the n-type electron transport layer; and a silver grid electrode having a width of 50 μm was formed on the surface thereof, thereby finally obtaining a solar cell.

In the following Examples and Comparative Examples, solar cells were produced and evaluated with the same configuration as above, except for the configuration of the light-absorbing layer.

1. Introduction of InSe layer

1.1. Formation of light-absorbing layer

(Example 1)

Example 1 adopts a precursor structure as shown in Figure 1. In Example 1, an InGaSe layer, a CuSe layer, and an InSe layer were formed respectively by a sputtering method. In Example 1, the InGaSe layer, the CuSe layer, and the InSe layer were formed in this order to thicknesses of 900 nm, 800 nm, and 400 nm, respectively, thereby producing a precursor. The precursor was crystallized through heating at 400°C or higher and 600°C or lower in a nitrogen atmosphere, and after the crystallization step, surface treatment was performed to treat the surface of the light-absorbing layer in a sulfur atmosphere at 500°C or higher and 600°C or lower, thereby obtaining a light-absorbing layer.

<Conditions during film formation by sputtering>

· Applied power: 0.5 to 3.0 W/cm$^2$
· Film formation atmosphere: argon
· Pressure during film formation: 0.2 Pa or more and 3.0 Pa or less
· Substrate temperature: room temperature
· Target type: a mixture of $In_2Se_3$ and $Ga_2Se_3$ with a proportion of $Ga_2Se_3$ being 30% or more and 60% or less for the InGaSe layer; $CuSe_2$ alone for the CuSe layer; and $In_2Se_3$ alone for the InSe layer

(Comparative Example 1)

In Comparative Example 1, sputtering was performed in the same manner as the method described in non-patent literature (Zhu, X. L., & Wang, L. K. (2014),13.6%-efficient Cu(In,Ga)Se2 solar cell with absorber fabricated by RF sputtering of (In,Ga)2Se3 and CuSe targets, Solar Energy Materials and Solar Cells, 124, 21-25.), and an InGaSe layer and a CuSe layer were formed in this order to 1700 nm and 400 nm, respectively, thereby producing a precursor. The precursor was crystallized through heating at 400°C or higher and 600°C or lower in a nitrogen atmosphere, and after the crystallization step, surface treatment was performed to treat the surface of the light-absorbing layer in a sulfur atmosphere

at 500°C or higher and 600°C or lower, thereby obtaining a light-absorbing layer of Comparative Example 1.

1.2. Evaluation

For the obtained light-absorbing layer, photoluminescence intensity (PL intensity) and band gap [eV] were measured using a near-infrared fluorescence lifetime estimation device manufactured by Hamamatsu Photonics K.K. A wavelength of incident light used was 532 nm. The obtained results are shown in Table 1. Generally, higher PL intensity suggests higher crystal quality, and it was suggested that the crystal quality of the light-absorbing layer of Example 1 was dramatically improved.

[Table 1]

| | Example 1 | Comparative Example 1 |
|---|---|---|
| Configuration of precursor | CuSe<br>InSe<br>InGaSe | CuSe<br>InGaSe |
| PL intensity (a.u.) | $3.9 \times 10^5$ | $0.5 \times 10^5$ |
| Band gap (eV) | 1.03 | 1.12 |

2. Aspects of precursor

2.1. Formation of light-absorbing layer

(Example 2 and Example 3)

Examples 2 and 3 adopt precursor structures as shown in Figures 2 and 3, respectively. In Examples 2 and 3, the order of stacking was changed under the same sputtering conditions as in Example 1 described above.

In Example 2, the CuSe layer was formed closer to the substrate side than the InSe layer compared to Example 1, and the thicknesses of the InGaSe layer, the CuSe layer, and the InSe layer were set to 900 nm, 400 nm, and 800 nm, respectively. In Example 3, the InGaSe layer and the CuSe layer were repeatedly formed, and then the InSe layer was formed. The thicknesses of the InGaSe layer, the CuSe layer, and the InSe layer were 450 nm, 200 nm, and 800 nm, respectively, and layers of the same compound were stacked with the same thickness. The precursor of each of Examples was crystallized through heating at 400°C or higher and 600°C or lower in a nitrogen atmosphere, and after the crystallization step, surface treatment was performed to treat the surface of the light-absorbing layer in a sulfur atmosphere at 500°C or higher and 600°C or lower, thereby obtaining a light-absorbing layer.

2.2. Evaluation of cell characteristics

(Conversion efficiency)

Solar cells were produced as described above, and I-V curves were measured under standard test conditions (test conditions in which light with spectral spectrum AM 1.5 was incident at an irradiance of 1 kW/m$^2$ and the solar cell temperature was 25°C). The conversion efficiency and fill factor of each solar cell were calculated using equations below. The conversion efficiency is calculated as the output at the optimum operating point on the I-V curve (maximum output: Pmax) divided by the light energy E received by the solar cell; and the fill factor is calculated as the maximum output Pmax divided by the product of the open-circuit voltage (Voc) and the short-circuit current (Isc). The values obtained by the measurement are shown in Table 2.

$$\text{Conversion efficiency (\%)} = (\text{Pmax}/\text{E}) \times 100$$

$$\text{Fill factor (\%)} = \text{Pmax}/(\text{Voc} \times \text{Isc})$$

[Table 2]

| | Example 1 | Example 2 | Example 3 |
|---|---|---|---|
| Configuration of precursor | CuSe / InSe / InGaSe | InSe / CuSe / InGaSe | InSe / CuSe / InGaSe / CuSe / InGaSe |
| Conversion efficiency (%) | 14.1 | 15.5 | 16.0 |
| Open-circuit voltage (mV) | 629 | 611 | 635 |
| Short-circuit current ($mA/cm^2$) | 33.9 | 37.9 | 34.8 |
| Fill factor (%) | 66.3 | 67.0 | 72.2 |

3. Amount of Group III element in InGaSe layer and InSe layer

3.1. Formation of light-absorbing layer

(Formation of light-absorbing layers with different amounts of Group III elements)

When forming a light-absorbing layer in the same manner as in Example 1 described above, the proportions of In element and Ga element were defined as shown in Table 3 in order to examine the contents of In element and Ga element contained in the InGaSe layer and the InSe layer. In each row of Table 3, the ratio value of the Ga element to the total amount of substance of In element and Ga element in the InGaSe layer is defined. In addition, in each column, the ratio (Y/X) of the total amount of substance Y of In element and Ga element in the InGaSe layer to the amount of substance X of In element in the InSe layer is defined. As a result, the value of Ga/(In + Ga) in the entire light-absorbing layer is as shown in Table 3.

Among the conditions shown, light-absorbing layers corresponding to the conditions assigned with numbers (1) to (6) were produced.

[Table 3]

| Ga/(In+Ga) ratio throughout entire light-absorbing layer | | Ratio of amount of Group III element in InGaSe layer and InSe layer (InGaSe:InSe) | | | | |
|---|---|---|---|---|---|---|
| | | 7:3 | 6:4 | 5:5 | 4:6 | 3:7 |
| | | 2.33 | 1.50 | 1.00 | 0.67 | 0.43 |
| Ga/(In+Ga) ratio in InGaSe layer | 0.30 | 0.21 | **(1) 0.18** | 0.15 | 0.12 | 0.09 |
| | 0.50 | **(2) 0.35** | **(3) 0.30** | 0.25 | 0.20 | 0.15 |
| | 0.60 | 0.42 | **(4) 0.36** | **(5) 0.30** | 0.24 | 0.18 |
| | 0.75 | 0.53 | 0.45 | 0.38 | **(6) 0.30** | 0.23 |
| | 1.00 | 0.70 | 0.60 | 0.50 | 0.40 | 0.30 |

3.2. Evaluation of cell characteristics

(Relative ratio of conversion efficiency)

Solar cells were produced using light-absorbing layers satisfying the conditions (1) to (7) described above, and conversion efficiency thereof was measured. The measurement of conversion efficiency was performed by the same method as in 2.2. above. The conversion efficiency of the solar cells obtained from the conditions (3) and (5) was the largest, and based on these values, a ratio of conversion efficiency measured under each condition was determined. The results are shown in Table 4.

[Table 4]

| Relative ratio of conversion efficiency | | Ratio of amount of Group III element in InGaSe layer and InSe layer (InGaSe:InSe) | | | | |
|---|---|---|---|---|---|---|
| | | 7:3 | 6:4 | 5:5 | 4:6 | 3:7 |
| | | 2.33 | 1.50 | 1.00 | 0.67 | 0.43 |
| Ga/(In+Ga) ratio in InGaSe layer | 0.30 | - | **(1) 0.97** | - | - | - |
| | 0.50 | **(2) 0.77** | **(3) 1.00** | - | - | - |
| | 0.60 | - | **(4) 0.90** | **(5) 1.00** | - | - |
| | 0.75 | - | - | - | **(6) 0.70** | - |
| | 1.00 | - | - | - | - | - |

4. Amount of Se element in each layer

4.1. Formation of light-absorbing layer

In order to examine the influence of the amount of Se element contained in the Group I-based CuSe layer and the Group III-based InGaSe layer and InSe layer, the amount-of-substance ratio (Se/Cu) of Se element to Cu element in the CuSe layer was set as shown in Table 5 and Table 6. Furthermore, the amount-of-substance ratio (Se/(In + Ga)) of Se element to the total amount of Group III elements (In + Ga) in the InGaSe layer and the InSe layer was set as shown in Table 5 and Table 6. Light-absorbing layers having seven different compositions ((7) to (20)) were produced for the case where the precursor was formed by stacking in the same manner as in Example 1 (Table 5) and the case where the precursor was formed by stacking in the same manner as in Example 2 (Table 6), with respect to each set amount-of-substance ratio of S element.

4.2. Evaluation of cell characteristics

(Conversion efficiency)

Solar cells were produced using the light-absorbing layers of (7) to (20), and results of measuring conversion efficiency are shown in Table 5 and Table 6.

[Table 5]

CuSe
InSe
InGaSe

| Conversion efficiency (%) | | Se/Cu ratio in CuSe layer | | |
|---|---|---|---|---|
| | | 2.0 | 2.5 | 3.0 |
| Se/(In+Ga) ratio in InGaSe • InSe layer | 1.25 | (7) 10.1 | - | - |
| | 1.50 | (8) 13.6 | (9) 14.1 | (10) 9.8 |
| | 1.75 | (11) 13.2 | (12) 13.3 | (13) 13.2 |

[Table 6]

InSe
CuSe
InGaSe

| Conversion efficiency (%) | | Se/Cu ratio in CuSe layer | | | |
|---|---|---|---|---|---|
| | | 0.5 | 1.0 | 1.5 | 2.0 |
| Se/(In+Ga) ratio in InGaSe • InSe layer | 1.00 | - | (14) 12.2 | - | - |
| | 1.25 | - | (15) 12.1 | (16) 10.5 | - |
| | 1.50 | (17) 15.5 | (18) 13.2 | (19) 15.2 | (20) 14.7 |

5. Evaluation of crystallinity of each layer

An InGaSe layer, a CuSe layer, and an InSe layer were each formed on a Ti metal substrate in the same manner as the method for forming each layer in the precursor formation step of Example 1 described above, and X-ray diffraction measurement was performed. The measurement was a 2θ-θ measurement with Cu-Kα radiation using an X-ray diffractometer manufactured by Malvern Panalytical. The results of the obtained diffraction measurement are shown in Figure 5.

Regarding the CuSe layer, growth of the (111) plane and the (220) plane was confirmed around 27° and 45°. In the InGaSe layer and the InSe layer, no significant peak indicating crystallinity was confirmed.

6. Formation temperature of InSe layer

An InSe layer was formed on a Ti metal substrate by the same formation method as in the precursor formation step of Example 1 described above, except that the surface temperature of the substrate was changed. Film formation was performed four times with the surface temperature of the substrate during formation set to room temperature (RT), 200°C, 250°C, and 300°C.

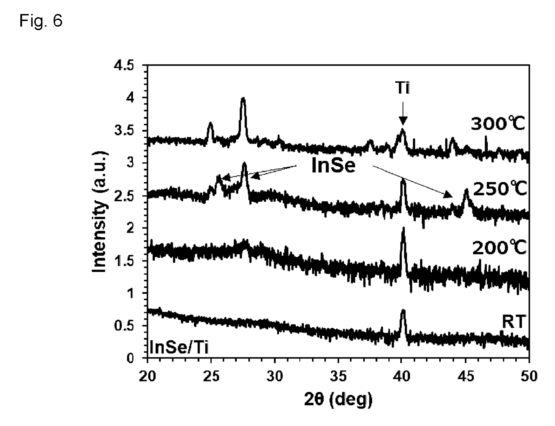

X-ray diffraction measurement was performed using the X-ray diffractometer and measurement conditions described above. The results of the obtained diffraction measurement are shown in Figure 6. From the results shown in Figure 6, it was found that the higher the surface temperature of the substrate, the higher the crystallinity of the formed InSe layer.

Furthermore, as a result of performing a similar test on the InGaSe layer, it was found that crystallization tends to proceed when a surface temperature higher than that for the InSe layer was set.

## Reference Signs List

10: solar cell
101: grid electrode
102: second electrode layer
103: electron transport layer
104: light-absorbing layer
105: hole transport layer
106: first electrode layer
107: substrate

## Claims

**1.** A method for manufacturing a solar cell, comprising:

a precursor formation step of forming a precursor including an InGaSe layer, a CuSe layer, and an InSe layer; and
a crystallization step of obtaining a crystallized light-absorbing layer by heating the precursor.

**2.** The method for manufacturing a solar cell according to Claim 1, wherein, in the precursor formation step, the InGaSe layer and the InSe layer are amorphous.

**3.** The method for manufacturing a solar cell according to Claim 1, wherein, in the precursor formation step, the respective layers are formed by a sputtering method and/or a vapor deposition method at 200°C or lower.

**4.** The method for manufacturing a solar cell according to Claim 1, wherein, in the precursor formation step, the InSe layer is formed on a light-receiving surface side with respect to the InGaSe layer.

**5.** The method for manufacturing a solar cell according to Claim 1, wherein, in the precursor formation step, the InSe layer is formed closest to a light-receiving surface side.

**6.** The method for manufacturing a solar cell according to Claim 1, wherein, in the precursor formation step, two or more layers of each of the InGaSe layer and the CuSe layer are formed.

**7.** The method for manufacturing a solar cell according to Claim 1, wherein, in the InGaSe layer, a ratio value (Ga/(In + Ga)) of an amount of substance of Ga element to a total amount of substance of In element and Ga element is 0.3 or more and 0.6 or less.

**8.** The method for manufacturing a solar cell according to Claim 1, wherein a ratio value (Y/X) of a total amount of substance Y of In element and Ga element in the InGaSe layer to an amount of substance X of In element in the InSe layer is 0.5 or more and 2.5 or less.

**9.** The method for manufacturing a solar cell according to Claim 1, wherein, in the precursor,

a ratio value (Ga/(In + Ga)) of an amount of substance of Ga element to a total amount of substance of In element and Ga element is 0.15 or more and 0.40 or less,
a ratio value (Cu/(In + Ga)) of an amount of substance of Cu element to the total amount of substance of In element and Ga element is 0.75 or more and 0.95 or less, and
a ratio value (Se/(Cu + In + Ga)) of an amount of substance of Se element to a total amount of substance of Cu element, In element, and Ga element is 1.0 or more.

**10.** The method for manufacturing a solar cell according to Claim 1, wherein, in the InGaSe layer and the InSe layer, a ratio value (Se/(In + Ga)) of an amount of substance of Se element to a total amount of substance of In element and Ga element is 1.25 or more and 1.75 or less.

**11.** The method for manufacturing a solar cell according to Claim 1, wherein, when the CuSe layer is formed as an

outermost layer of the precursor, in the CuSe layer, a ratio value (Se/Cu) of an amount of substance of Se element to an amount of substance of Cu element is 2.0 or more and 3.0 or less.

**12.** The method for manufacturing a solar cell according to Claim 1, wherein, when the CuSe layer is formed as a layer other than an outermost layer of the precursor, in the CuSe layer, a ratio value (Se/Cu) of an amount of substance of Se element to an amount of substance of Cu element is 0.5 or more and 2.0 or less.

**13.** The method for manufacturing a solar cell according to Claim 1, wherein, in the crystallization step, the heating is performed under an inert atmosphere at 300°C or higher and 600°C or lower.

**14.** The method for manufacturing a solar cell according to Claim 1, further comprising, after the crystallization step: a surface treatment step of treating a surface of the light-absorbing layer under a sulfur atmosphere at 350°C or higher and 600°C or lower.

**15.** A solar cell manufactured by the method according to any one of Claims 1 to 14, wherein, in the light-absorbing layer,

a band gap in a section from a light-receiving surface side to a depth of 200 nm is 1.1 eV or more and 1.4 eV or less,
a band gap in a section from a depth of 200 nm to a depth of 400 nm measured from the light-receiving surface side is 0.9 eV or more and 1.2 eV or less, and
a band gap in a section at a depth of more than 400 nm measured from the light-receiving surface side is 1.2 eV or more and 1.7 eV or less.

Fig. 1

CuSe
InSe
InGaSe

precursor

Fig. 2

InSe
CuSe
InGaSe

precursor

Fig. 3

InSe
CuSe
InGaSe
CuSe
InGaSe

precursor

Fig. 4

101
102
103
104
105
106
107
10

Fig. 5

Ti
CuSe
InSe/Ti
CuSe/Ti
InGaSe/Ti
Intensity (a.u.)
2θ (deg)
3.5
3
2.5
2
1.5
1
0.5
0
20
30
40
50
60

Fig. 6

Ti
300℃
InSe
250℃
200℃
RT
InSe/Ti
Intensity (a.u.)
2θ (deg)
4.5
4
3.5
3
2.5
2
1.5
1
0.5
0
20
25
30
35
40
45
50

## INTERNATIONAL SEARCH REPORT

International application No. **PCT/JP2024/035832**

**A. CLASSIFICATION OF SUBJECT MATTER**

***H10F 10/167***(2025.01)i; ***H10F 10/16***(2025.01)i; ***H10F 10/161***(2025.01)i; ***H10K 30/40***(2023.01)i; ***H10K 39/15***(2023.01)i
FI: H01L31/06 460; H10K39/15; H10K30/40; H01L31/06 400; H01L31/06 410

According to International Patent Classification (IPC) or to both national classification and IPC

**B. FIELDS SEARCHED**

Minimum documentation searched (classification system followed by classification symbols)

H01L31/02-31/078; H01L31/18-31/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JSTChina/JST7580 (JDreamIII)

**C. DOCUMENTS CONSIDERED TO BE RELEVANT**

| Category* | Citation of document, with indication, where appropriate, of the relevant passages | Relevant to claim No. |
|---|---|---|
| Y | JP 2016-518032 A (SK INNOVATION CO., LTD.) 20 June 2016 (2016-06-20) paragraphs [0029]-[0036], fig. 1 | 1-14 |
| Y | JP 2013-84664 A (ASAHI GLASS COMPANY, LIMITED) 09 May 2013 (2013-05-09) paragraph [0027] | 1-14 |
| X | WO 2004/090995 A1 (MATSUSHITA ELECTRIC INDUSTRIAL CO., LTD.) 21 October 2004 (2004-10-21) page 31, table 14 | 15 |
| A | US 2015/0303328 A1 (KOREA INSTITUTE OF ENERGY RESEARCH) 22 October 2015 (2015-10-22) entire text, all drawings | 1-15 |
| A | JP 2002-217213 A (MATSUSHITA ELECTRIC INDUSTRIAL CO., LTD.) 02 August 2002 (2002-08-02) entire text, all drawings | 1-15 |

☑ Further documents are listed in the continuation of Box C. ☑ See patent family annex.

* Special categories of cited documents:
- "A" document defining the general state of the art which is not considered to be of particular relevance
- "D" document cited by the applicant in the international application
- "E" earlier application or patent but published on or after the international filing date
- "L" document which may throw doubts on priority claim(s) or which is cited to establish the publication date of another citation or other special reason (as specified)
- "O" document referring to an oral disclosure, use, exhibition or other means
- "P" document published prior to the international filing date but later than the priority date claimed
- "T" later document published after the international filing date or priority date and not in conflict with the application but cited to understand the principle or theory underlying the invention
- "X" document of particular relevance; the claimed invention cannot be considered novel or cannot be considered to involve an inventive step when the document is taken alone
- "Y" document of particular relevance; the claimed invention cannot be considered to involve an inventive step when the document is combined with one or more other such documents, such combination being obvious to a person skilled in the art
- "&" document member of the same patent family

| Date of the actual completion of the international search | Date of mailing of the international search report |
|---|---|
| **06 December 2024** | **24 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

INTERNATIONAL SEARCH REPORT

International application No. PCT/JP2024/035832

C. DOCUMENTS CONSIDERED TO BE RELEVANT

| Category* | Citation of document, with indication, where appropriate, of the relevant passages | Relevant to claim No. |
|---|---|---|
| A | JP 2014-154760 A (NITTO DENKO CORPORATION) 25 August 2014 (2014-08-25) entire text, all drawings | 1-15 |
| A | JP 2003-179238 A (MATSUSHITA ELECTRIC INDUSTRIAL CO., LTD.) 27 June 2003 (2003-06-27) entire text, all drawings | 1-15 |
| A | JP 2003-318424 A (HONDA MOTOR CO., LTD.) 07 November 2003 (2003-11-07) entire text, all drawings | 1-15 |
| A | JP 2014-17426 A (PROMATIC KK) 30 January 2014 (2014-01-30) entire text, all drawings | 1-15 |

Form PCT/ISA/210 (second sheet) (July 2022)

**INTERNATIONAL SEARCH REPORT**
**Information on patent family members**

International application No.
**PCT/JP2024/035832**

| Patent document cited in search report | Publication date (day/month/year) | Patent family member(s) | Publication date (day/month/year) |
|---|---|---|---|
| JP 2016-518032 A | 20 June 2016 | US 2016/0064582 A1<br>paragraphs [0040]-[0047], fig. 1<br>WO 2014/182049 A1<br>KR 10-2014-0133139 A<br>TW 201447003 A<br>CN 105164820 A | |
| JP 2013-84664 A | 09 May 2013 | KR 10-2013-0037654 A<br>TW 201320375 A | |
| WO 2004/090995 A1 | 21 October 2004 | US 2006/0220059 A1<br>paragraph [0017], table 14<br>EP 1619728 A1<br>CN 1771610 A | |
| US 2015/0303328 A1 | 22 October 2015 | WO 2014/010926 A1<br>KR 10-2014-0010549 A<br>CN 104011879 A | |
| JP 2002-217213 A | 02 August 2002 | (Family: none) | |
| JP 2014-154760 A | 25 August 2014 | US 2015/0357492 A1<br>WO 2014/125899 A1<br>TW 201439353 A<br>CN 104969329 A | |
| JP 2003-179238 A | 27 June 2003 | (Family: none) | |
| JP 2003-318424 A | 07 November 2003 | (Family: none) | |
| JP 2014-17426 A | 30 January 2014 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H10135495 A
- JP 2012513127 W
- WO 2011052574 A
- WO 2011090959 A


### Non-patent literature cited in the description


- **ZHU, X. L.** ; **WANG, L. K.** 13.6%-efficient Cu(In,Ga) Se2 solar cell with absorber fabricated by RF sputtering of (In,Ga)2Se3 and CuSe targets. *Solar Energy Materials and Solar Cells*, 2014, vol. 124, 21-25